(19) Europäisches Patentamt
European Patent Office
Office européen des brevets

(11) **EP 2 523 279 B1**

(12) **EUROPÄISCHE PATENTSCHRIFT**

(45) Veröffentlichungstag und Bekanntmachung des Hinweises auf die Patenterteilung:
**15.11.2023 Patentblatt 2023/46**

(21) Anmeldenummer: **12166585.5**

(22) Anmeldetag: **03.05.2012**

(51) Internationale Patentklassifikation (IPC):
**H01S 5/20** (2006.01)

(52) Gemeinsame Patentklassifikation (CPC):
**H01S 5/2036; H01S 5/205;** H01S 5/20;
H01S 2301/18

(54) **Breitstreifen-Diodenlaser mit hoher Effizienz und geringer Fernfelddivergenz**

Wide stripe diode laser with high efficiency and low far-field divergence

Laser à diodes large bande à grande efficacité et faible divergence de champ distant

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.05.2011 DE 102011075502**

(43) Veröffentlichungstag der Anmeldung:
**14.11.2012 Patentblatt 2012/46**

(73) Patentinhaber: **Ferdinand-Braun-Institut gGmbH, Leibniz-Institut für Höchstfrequenztechnik 12489 Berlin (DE)**

(72) Erfinder:
• **Crump, Paul**
  **10245 Berlin (DE)**
• **Erbert, Götz**
  **02708 Löbau (DE)**
• **Wenzel, Hans**
  **12355 Berlin (DE)**
• **Fricke, Jörg**
  **10319 Berlin (DE)**

(74) Vertreter: **Gulde & Partner Patent- und Rechtsanwaltskanzlei mbB Wallstraße 58/59 10179 Berlin (DE)**

(56) Entgegenhaltungen:
WO-A2-2006/096299    DE-A1-102008 058 436
US-A- 6 167 073

• CHAN A K ET AL: "Antiguiding index profiles in broad strip semiconductor lasers for high-power, single-mode operation", IEEE JOURNAL OF QUANTUM ELECTRONICS, IEEE SERVICE CENTER, PISCATAWAY, NJ, USA, Bd. 24, Nr. 3, 1. März 1988 (1988-03-01), Seiten 489-495, XP011478372, ISSN: 0018-9197, DOI: 10.1109/3.150

**Beschreibung**

Die vorliegende Erfindung betrifft einen Diodenlaser mit hoher Effizienz und geringer Fernfelddivergenz.

*Stand der Technik*

Generell besitzen Laserdioden (nachfolgend auch als Diodenlaser bezeichnet) eine aktive Schicht, welche in Halbleiterschichten eingebettet sind, die sich durch ihre Bandlücken, Brechzahlen und Dotierung voneinander unterscheiden. Die Schichten unterhalb und oberhalb der aktiven Schicht unterscheiden sich durch den Leitungstyp (n oder p). Neben der Gewährleistung des Transports von Elektronen und Löchern zur aktiven Schicht, wo sie stimuliert rekombinieren und Laserstrahlung erzeugen, dienen diese Schichten der vertikalen Führung des Laserlichtes. Die der aktiven Schicht benachbarten Schichten werden als Wellenleiterschichten bezeichnet, die diesen Schichten benachbarten als Mantelschichten. Typischerweise ist die Brechzahl der aktiven Schicht größer als die der Wellenleiterschichten und die Brechzahl der Wellenleiterschichten größer als die der Mantelschichten. Jedoch sind auch andere Konfigurationen möglich (z. B. Vertical ARROW, Photonic Band Crystal).

Parameter wie Leistung, Effizienz, Strahlgüte, schmale spektrale Linienbreite und Zuverlässigkeit von Hochleistungsdiodenlasern sind wichtige Kriterien für deren Einsatz anstelle von Festkörperlasern. Einzelbreitstreifenlaser sind auf hohe optische Ausgangsleistungen optimierte Diodenlaser. Hohe Leistungen werden durch das Pumpen großer Flächen mit Aperturen (Streifenbreiten) größer als 10 $\mu$m, beispielsweise zwischen 30 und 400 $\mu$m und Resonatorlängen bis zu 10 mm erzielt.

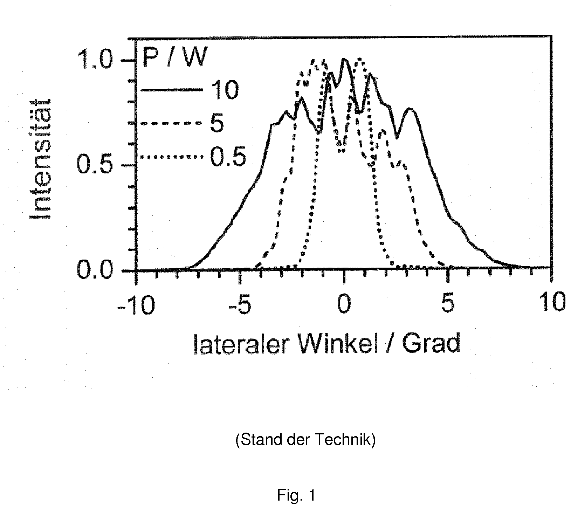

Der Einsatz von Breitstreifenlasern hoher Ausgangsleistung anstelle von Festkörperlasern wird jedoch dadurch beschränkt, dass die laterale Divergenz der emittierten Strahlung mit zunehmender Ausgangsleistung immer größer wird. Dadurch nimmt die Fokussierbarkeit der emittierten Strahlung ab, was für viele Anwendungen z. B. in der Materialbearbeitung nachteilhaft ist. Hauptursache für diesen Effekt ist die Ausbildung eines thermisch induzierten Wellenleiters, der mit zunehmender Ausgangsleistung zum stabilen Lasen von lateralen Moden (immer) höherer Ordnung führt. Da die Divergenz des Fernfeldes mit zunehmender Ordnung der lateralen Moden zunimmt, führen höhere Ausgangsleistungen zu einer ungewollten lateralen Aufweitung des Strahls, wie aus Fig. 1 ersichtlich ist.

Fig. 1 zeigt die Intensitätsverteilung des lateralen Fernfeldes eines herkömmlichen Breitstreifenlasers mit 90 $\mu$m Streifenbreite für verschiedene Ausgangsleistungen.

Ein Teil des in den Laser fließenden Stromes und der Teil des entstehenden Lichtes, welcher wieder absorbiert wird, erwärmen diesen. Die Erwärmung findet insbesondere im aktiven Gebiet direkt unter dem oberen, stromdurchflossenen Kontaktstreifen statt. Dies führt zu einer lokalen Erhöhung der Brechzahlen, da die Brechzahlen der verwendeten Verbindungshalbleiter bei der Laserwellenlänge mit zunehmender Temperatur größer werden. Durch die positive Differenz der Brechzahlen zwischen dem aktiven Gebiet und dem seitlichen passiven Gebiet (das nicht direkt unterhalb des Kontaktstreifens liegt) bildet sich ein lateraler Wellenleiter heraus, der mehrere laterale Moden führen kann. Mit zunehmender Ausgangsleistung nimmt die Brechzahldifferenz immer mehr zu, so dass laterale Moden mit immer höherer Ordnung geführt werden und die Laserschwelle erreichen.

Zur Verringerung der lateralen Fernfelddivergenz schlägt US 4,965,806 A vor, in den oberen Wellenleiter eine laterale Schichtdickenvariation zur Kompensation der Brechzahlerhöhung einzuprägen. Dies ist jedoch nachteilhaft, da die durch die Schichtdickenvariation erzeugte Kompensation nur für eine bestimmte Ausgangsleistung realisiert werden kann. Weiterhin nachteilhaft sind die hohen Kosten bei der Realisierung eines nicht-planaren Wellenleiters.

In einer weiteren Ausführungsvariante schlägt US 4,965,806 A ein eingeprägtes laterales Temperaturprofil vor, das durch seitlich des aktiven Gebiets angeordnete Heizelemente erzeugt wird. Der Nachteil dieser Vorrichtung besteht darin, dass weitere elektrische Anschlüsse erforderlich sind. Weiterhin ist diese Vorrichtung nicht mit einer p-down-Montage zur besseren Wärmeabführung kompatibel. Darüber hinaus sind die hohen Kosten der zusätzlichen Heizelemente nachteilhaft.

Zur Unterdrückung lateraler Moden höherer Ordnung schlagen US 6,141,365 A und WO 2004/027951 A1 seitlich des aktiven Gebiets angeordnete, absorbierende Schichten vor, die insbesondere zu Verlusten bei lateralen Moden höherer Ordnung führen. Solche absorbierenden Schichten können jedoch nur für kleine Streifenbreiten < 10 $\mu$m, d. h. für Leistungen < 2 W sinnvoll eingesetzt werden, da die lateralen Moden höherer Ordnung von Breitstreifenlasern hauptsächlich im aktiven Gebiet lokalisiert sind und daher durch seitlich angeordnete, absorbierende Schichten nicht oder nur geringfügig beeinflusst werden können. Darüber hinaus lassen sich solche absorbierenden Schichten nur für Moden mit einem stark unterschiedlichem lateralen Profil einsetzen, da sonst die Grundmode ebenfalls zu stark abgeschwächt würde, was wiederum zu einer geringen Effizienz der Vorrichtung führt.

WO 2010/057955 A1 verwendet Gitterstrukturen zur Verminderung der Rückkopplung höherer Moden, jedoch ist die Herstellung der Gitterstrukturen aufwändig und damit kostenintensiv.

US 6,167,073 A offenbart einen Hochleistungs-Halbleiterlaser umfassend eine Vielzahl von parallel nebeneinander angeordneten Laserelementen, zwischen denen lateral antiwellenleitende Bereiche mit einem reduziertem transversalen optischen Einschluss zur Kopplung der einzelnen Laserelemente ausgebildet sind, wobei sich neben einem stromführenden Kernbereich jeweils Hochindex-Bereiche befinden. Weitere Halbleiterlaser mit lateralen Antiwellenleiterstrukturen in Randbereichen werden in WO 2006/096299 A2 und DE 10 2008 058 436 A1 vorgeschlagen, wobei DE 10 2008 058 436 A1 den Oberbegriff des Anspruchs 1 offenbart. Entsprechende lateral antiwellenleitende Brechzahlprofile in Breitstreifen-Halbleiterlasern für den Hochleistungs-Einzelmodenbetrieb werden in A. K. Chan et al., IEEE J. Quantum. Elec. 24(3) (1988) beschrieben.

*Offenbarung der Erfindung*

Es ist daher Aufgabe der vorliegenden Erfindung, einen Breitstreifenlaser mit einer geringen Fernfelddivergenz bei gleichzeitig hoher Ausgangsleistung anzugeben. Weiterhin soll der erfindungsgemäße Breitstreifenlaser preisgünstig herstellbar sein.

Diese Aufgaben werden erfindungsgemäß durch die Merkmale des Patentanspruchs 1 gelöst. Zweckmäßige Ausgestaltungen der Erfindung sind in den Unteransprüchen enthalten.

Die Idee der vorliegenden Erfindung besteht darin, seitlich außerhalb, bevorzugt vollständig außerhalb, des aktiven, stromdurchflossenen Gebietes eine zusätzlich Schicht, im Folgenden auch Antiwellenleiterschicht genannt, einzufügen. Diese Schicht besitzt eine hinreichend große Brechzahl. Bei bestimmten, von der Brechzahl abhängigen Dicken der Schichten findet eine resonante Auskopplung lateraler Obermoden in diese Antiwellenleiterschichten statt, welche umso größer ist, je höher die Modenordnung ist. Durch diese Auskopplung erfahren die lateralen Moden Verluste, welche mit der Modenordnung zunehmen. Daher können laterale Obermoden erfindungsgemäß durch resonante Auskopplung unterdrückt werden. Daher können Wellenleiter- und Mantelschicht vorteilhafterweise planar ausgebildet werden und es kann auf zusätzliche Heizelemente verzichtet werden. Da die Unterdrückung der lateralen Moden höherer Ordnung durch resonante Auskopplung und nicht durch Absorption erfolgt, kann die Antiwellenleiterschicht zwar (stark) absorbierend sein, dies ist jedoch nicht Voraussetzung. Ein weiterer Vorteil besteht darin, dass eine resonant auskoppelnde Antiwellenleiterschicht insbesondere in Diodenlasern mit schwach unterschiedlichem lateralen Profil, d. h. bei Breitstreifenlasern effizient eingesetzt werden kann.

Der erfindungsgemäße Diodenlaser weist einen ersten Kontakt, eine erste Mantelschicht, eine erste Wellenleiterschicht, eine aktive Schicht, eine zweite Wellenleiterschicht, zweite Mantelschicht und einen zweiten Kontakt auf, die vorzugsweise als Schichtenstapel ausgebildet sind. Um einen Laserbetrieb zu ermöglichen, erstrecken sich die aktive Schicht, der erste Kontakt und der zweite Kontakt jeweils zumindest teilweise zwischen einer Austrittsfacette und einer Reflexionsfacette.

Erfindungsgemäß besitzen die aktive Schicht, der erste Kontakt und der zweite Kontakt jeweils eine Breite größer als 10 $\mu$m und eine Antiwellenleiterschicht ist seitlich außerhalb des zwischen den Kontakten eingeschlossenen, aktiven Gebiets angeordnet, wobei die Brechzahl der Antiwellenleiterschicht mindestens größer als die minimale Brechzahl der Mantelschichten ist, wobei der minimale Abstand zwischen der Antiwellenleiterschicht und einer Projektion einer der Kontakte in die Ebene der Antiwellenleiterschicht zwischen 0 und 50 $\mu$m, bevorzugter zwischen 5 und 50 $\mu$m und noch bevorzugter zwischen 10 und 50 $\mu$m beträgt. Ein minimaler Abstand größer als 0 $\mu$m ist bevorzugt, um unerwünschte Verluste für die Moden kleinerer Ordnung zu minimieren.

In einer bevorzugten Ausführungsvariante der Erfindung ist jeweils eine Antiwellenleiterschicht an jeder Seite des aktiven Gebiets zwischen den Facetten angeordnet. Die mindestens eine Antiwellenleiterschicht befindet sich lateral seitlich (außerhalb) des aktiven Gebietes und vertikal an einer beliebigen Position innerhalb der seitlichen Schichtenfolge. Die optimale Position hängt von den verwendeten Materialien ab. Die Antiwellenleiterschicht kann sich unterhalb oder oberhalb einer der beiden Mantelschichten, innerhalb einer der Mantelschichten oder bevorzugt im Bereich zwischen den beiden Mantelschichten befinden. Das aktive Gebiet im Sinne der vorliegenden Erfindung ist - sofern beide Kontakte über ihre Länge die gleiche Breite aufweisen - das zwischen den Kontakten eingeschlossene Gebiet. Sofern beide Kontakte über ihre Länge (zumindest teilweise) unterschiedliche Breiten aufweisen, ist das aktive Gebiet im Sinne der vorliegenden Erfindung derjenige Bereich, der durch senkrechte Projektion des (jeweils) weniger breiten Kontakts auf den gegenüberliegenden Kontakt eingeschlossen wird.

Vorzugsweise erstrecken sich die aktive Schicht, der erste Kontakt und der zweite Kontakt jeweils vollständig zwischen der Austrittsfacette und der Reflexionsfacette, dies ist jedoch nicht zwingend notwendig. Vorzugsweise erstreckt sich die mindestens eine Antiwellenleiterschicht ebenfalls vollständig zwischen den Facetten, jedoch ist auch dies nicht zwingend notwendig. Vorzugsweise erstreckt sich die mindestens eine Antiwellenleiterschicht über mindestens 30%, bevorzugter über mindestens 50% und noch bevorzugter über mindestens 80% der Längserstreckung der aktiven Schicht.

Der effektive Brechungsindex $n1_{eff}$ im aktiven Gebiet ist durch die Lösung der folgenden eindimensionalen vertikalen Wellenleitungsgleichung

$$\frac{\mathrm{d}^2 E_{\text{aktives Gebiet}}}{\mathrm{d}\,y^2} + \frac{4\pi^2}{\lambda^2}\left(n_{\text{aktives Gebiet}}(y)^2 - n1_{\text{eff}}^2\right)E_{\text{aktives Gebiet}}(y) = 0$$

definiert, wobei $n_{\text{aktives Gebiet}}(y)$ das Profil der Brechzahlen der Schichtenfolge im aktiven Gebiet, $\lambda$ die Laserwellenlänge, $E_{\text{aktives Gebiet}}(y)$ das Profil der elektrischen Feldstärke im aktivem Gebiet, und y vertikale Ortskoordinate im aktivem Gebiet sind. Die Lösung für $n1_{\text{eff}}$, deren Absolutquadrat der elektrischen Feldstärke in der aktiven Schicht am größten ist, bestimmt das vertikale Profil der elektrischen Feldstärke der Lasermoden im aktiven Gebiet. Die Schichtenfolge besteht in diesem Fall mindestens aus der ersten Mantelschicht, der ersten Wellenleiterschicht, der aktiven Schicht, der zweiten Wellenleiterschicht und der zweiten Mantelschicht. Die außen liegenden Kontakt- und Substratschichten können per Bedarf auch berücksichtigt werden. Der effektive Brechungsindex $n2_{\text{eff}}$ im Bereich seitlich (außerhalb) des aktiven Gebiets, in dem die Antiwellenleiterschicht angeordnet ist, ist durch die Lösung der folgenden eindimensionalen vertikalen Wellenleitungsgleichung

$$\frac{\mathrm{d}^2 E_{\text{seitlich}}}{\mathrm{d}\,y^2} + \frac{4\pi^2}{\lambda^2}\left(n_{\text{seitlich}}(y)^2 - n2_{\text{eff}}^2\right)E_{\text{seitlich}}(y) = 0$$

definiert, wobei $n_{\text{seitlich}}(y)$ das Profil der Brechzahlen der Schichtenfolge im Gebiet seitlich des aktiven Gebiets, in dem die Antiwellenleiterschicht angeordnet ist, $\lambda$ die Laserwellenlänge, $E_{\text{seitlich}}(y)$ das Profil der elektrischen Feldstärke im Gebiet seitlich des aktiven Gebiets, in dem die Antiwellenleiterschicht angeordnet ist und y vertikale Ortskoordinate im Gebiet seitlich des aktiven Gebiets, in dem die Antiwellenleiterschicht angeordnet ist, repräsentieren. Die Lösung für $n2_{\text{eff}}$, deren Absolutquadrat der elektrischen Feldstärke in der aktiven Schicht am größten ist, bestimmt das vertikale Profil der elektrischen Feldstärke der Lasermoden im Gebiet seitlich des aktiven Gebietes. Bei Vorhandensein der Antiwellenleiterschicht im Gebiet seitlich des aktiven Gebietes gibt es weitere Lösungen für $n2_{\text{eff}}$. Die Schichtenfolge besteht in diesem Fall aus der Antiwellenleiterschicht sowie allen der folgenden Schichten: erste Mantelschicht, erste Wellenleiterschicht, aktive Schicht, zweite Wellenleiterschicht und zweite Mantelschicht, sofern diese Schichten im Gebiet seitlich des aktiven Gebiets, in dem die Antiwellenleiterschicht angeordnet ist, vorhanden sind.

Die erfindungsgemäße resonante Auskopplung tritt auf, wenn die Brechzahl und die Dicke der Antiwellenleiterschicht so gewählt sind, dass im Laserbetrieb der effektive Index $n1_{\text{eff}}$ im aktiven Gebiet ungefähr gleich ist dem effektiven Index $n2_{\text{eff}}$ im Gebiet seitlich des aktiven Gebiets, in dem die Antiwellenleiterschicht angeordnet ist.

Die Dicke und die Brechzahl der mindestens einen Antiwellenleiterschicht sind so gewählt, dass für die Differenz von $n1_{\text{eff}}$ und $n2_{\text{eff}}$ gilt: $0 \le (n1_{\text{eff}} - n2_{\text{eff}}) < 0.15$, bevorzugter $< 0.10$, noch bevorzugter $< 0.05$. In einer bevorzugten Ausführungsvariante ist der effektive Brechungsindex $n1_{\text{eff}}$ im aktiven Gebiet größer als der effektive Brechungsindex $n2_{\text{eff}}$ im Bereich seitlich (außerhalb) des aktiven Gebiets.

Vorzugsweise ist an jeder Längsseite der aktiven Schicht je eine Antiwellenleiterschicht angeordnet. Vorzugsweise sind die zwei Antiwellenleiterschichten zueinander symmetrisch zu einer zentrierten Längsachse der aktiven Schicht angeordnet. Vorzugsweise sind Breite, Schichtdicke, Entfernung zum aktiven Gebiet und Brechzahl der zwei Antiwellenleiterschichten jeweils gleich.

Vorzugsweise ist die Brechzahl der mindestens einen Antiwellenleiterschicht größer als die minimale Brechzahl der Mantelschichten. Sofern die Brechzahlen der Mantelschichten gleich sind, ist die Brechzahl der mindestens einen Antiwellenleiterschicht größer als die Brechzahl der Mantelschichten.

Die Brechzahlen beziehen sich stets auf die Laserwellenlänge. Noch bevorzugter ist die Brechzahl der mindestens einen Antiwellenleiterschicht größer als das arithmetische Mittel der Brechzahlen der Mantelschichten. Vorzugsweise ist die Brechzahl der mindestens einen Antiwellenleiterschicht größer als die maximale Brechzahl der Mantelschichten.

Vorzugsweise ist die Brechzahl der mindestens einen Antiwellenleiterschicht größer als die minimale Brechzahl der Wellenleiterschichten. Sofern die Brechzahlen der Wellenleiterschichten gleich sind, ist die Brechzahl der mindestens einen Antiwellenleiterschicht vorzugsweise größer als die Brechzahl der Wellenleiterschichten.

Noch bevorzugter ist die Brechzahl der mindestens einen Antiwellenleiterschicht größer als das arithmetische Mittel der Brechzahlen der Wellenleiterschichten. Vorzugsweise ist die Brechzahl der mindestens einen Antiwellenleiterschicht größer als die maximale Brechzahl der Wellenleiterschichten.

Eine resonante Auskopplung der lateralen Moden höherer Ordnung kann durch die Antiwellenleiterschicht besonders effizient erfolgen, wenn deren Brechzahl vergleichsweise groß zu den Brechzahlen der Schichten im aktiven Gebiet ist.

Vorzugsweise ist der minimale vertikale Abstand zwischen der aktiven Schicht und der Antiwellenleiterschicht kleiner als die Summe der Schichtdicke der ersten Mantelschicht und der Schichtdicke der ersten Wellenleiterschicht. Vorzugsweise ist der minimale vertikale Abstand zwischen der aktiven Schicht und der Antiwellenleiterschicht kleiner als die Summe der Schichtdicke der zweiten Mantelschicht und der Schichtdicke der zweiten Wellenleiterschicht.

Vorzugsweise sind die erste Mantelschicht und die erste Wellenleiterschicht n-leitend und die zweite Mantelschicht und die zweite Wellenleiterschicht p-leitend ausgebildet.

Vorzugsweise ist der minimale vertikale Abstand zwischen der aktiven Schicht und der Antiwellenleiterschicht kleiner als die Schichtdicke der p-leitenden, zweiten Wellenleiterschicht. Noch bevorzugter beträgt der vertikale Abstand zwischen der aktiven Schicht und der Antiwellenleiterschicht zwischen 40% und 100% der Schichtdicke der zweiten Wellenleiterschicht.

Vorzugsweise ist der minimale laterale Abstand zwischen der Antiwellenleiterschicht und einer Projektion desjenigen Kontakts, der eine geringere Breite aufweist, in die Ebene der Antiwellenleiterschicht zwischen 0 und 50 $\mu$m, bevorzugter zwischen 5 und 50 $\mu$m, noch bevorzugter zwischen 10 und 50 $\mu$m. Dadurch kann eine resonante Auskopplung der lateralen Moden höherer Ordnung besonders effizient erfolgen, ohne Zusatzverlust für Moden kleinerer Ordnung.

Die aktive Schicht, der erste Kontakt und der zweite Kontakt weisen jeweils eine Breite größer 10 $\mu$m, bevorzugter zwischen 20 und 800 $\mu$m und noch bevorzugter zwischen 30 und 400 $\mu$m auf. Insbesondere sollen hohe Leistungen durch das Pumpen großer Flächen mit Aperturen (Streifenbreiten) größer als 10 $\mu$m, vorzugsweise zwischen 30 und 400 $\mu$m, bevorzugter zwischen 20 und 800 $\mu$m und noch bevorzugter zwischen 30 und 400 $\mu$m und Resonatorlängen bis zu 10 mm erzielt werden. Unabhängig von der Breite der Kontakte und der aktiven Schicht ist es erfindungsgemäß vorgesehen, dass das stromdurchflossene Gebiet im Bereich der aktiven Schicht eine Breite größer 10 $\mu$m, bevorzugter zwischen 20 und 800 $\mu$m und noch bevorzugter zwischen 30 und 400 $\mu$m aufweist.

Bevorzugt weist Antiwellenleiterschicht eine laterale Breite größer als $\lambda/n2_{eff}$ auf, bevorzugter größer als 10 x $\lambda/n2_{eff}$ und noch bevorzugter größer als 100 x $\lambda/n2_{eff}$. In einer bevorzugten Ausführungsvariante für den Fall $\lambda$ = 980nm und $n2_{eff}$ = 3.5, erstreckt sich die Antiwellenleiterschicht von beiden Seiten des stromdurchflossenen Gebiets weg, über einen Bereich von mindestens 2,8 $\mu$m, bevorzugter mindestens 10 $\mu$m und noch bevorzugter mindestens 28 $\mu$m. In einer besonders bevorzugten Ausführungsvariante erstreckt sich die Antiwellenleiterschicht von beiden Seiten des stromdurchflossenen Gebiets her in eine Richtung, die jeweils (lateral) vom stromdurchflossenen Gebiet wegführt, bis zu einem Bereich, in den sich Wellenleiter- und Mantelschichten (lateral) erstrecken. Besonders bevorzugt schließt sie Antiwellenleiterschicht (lateral) Wellenleiter- und Mantelschichten bündig ab.

Vorzugsweise ist für den Wellenlängenbereich zwischen 0.3 $\mu$m und 100 $\mu$m die Antiwellenleiterschicht aus Germanium ausgebildet. Anstelle von Germanium kann alternativ ein anderes Material (Halbleiter, Isolator, Metall) mit ausreichender Brechzahl verwendet werden. Beispielsweise hat GaAs im Wellenlängenbereich zwischen 0.25 $\mu$m und 1.55 $\mu$m eine ausreichend große Brechzahl. Die optimale Dicke hängt von der Brechzahl der Antiwellenleiterschicht und der Laserwellenlänge ab.

Vorzugsweise ist die Schichtstruktur aus erster Mantelschicht, erster Wellenleiterschicht, aktiver Schicht, zweiter Wellenleiterschicht und zweiter Mantelschicht auf einem halbleitenden Trägersubstrat angeordnet. Die Kontakte können vorzugsweise unterhalb des Substrats und oberhalb der oberen Wellenleiterschicht aufgebracht sein.

Vorzugsweise sind die erste Mantelschicht, die erste Wellenleiterschicht, die aktive Schicht, die zweite Wellenleiterschicht und die zweite Mantelschicht aus halbleitenden Materialien ausgebildet.

Vorzugsweise sind die erste Mantelschicht, die erste Wellenleiterschicht, die aktive Schicht, die zweite Wellenleiterschicht, die zweite Mantelschicht und die Antiwellenleiterschicht jeweils planar ausgebildet. Vorzugsweise weisen die erste Mantelschicht, die erste Wellenleiterschicht, die aktive Schicht, die zweite Wellenleiterschicht, die zweite Mantelschicht und die Antiwellenleiterschicht jeweils eine uniforme Schichtdicke auf.

Vorzugsweise sind die aktive Schicht, der erste Kontakt und/oder der zweite Kontakt streifenförmig ausgebildet. Anstelle eines rechteckigen Kontaktstreifens können alternativ beliebige Formen, z. B. trapezförmige Form (Breitstreifen-Trapezlaser) vorgesehen werden.

Es ist weiterhin möglich, den erfindungsgemäßen Diodenlaser als Mehrsektions-Laser mit unterschiedlichen Geometrien und Ausführungen des Kontaktstreifens, z. B. Trapezlaser bestehend aus einer RW-(Ridge-Waveguide)-Sektion und einer Trapez-Sektion, auszuführen. Es sind auch andere, alternative Ausgestaltungen mit mehreren Sektionen denkbar.

Der minimale laterale Abstand zwischen der Antiwellenleiterschicht und einer Projektion desjenigen Kontakts, der eine geringere Breite aufweist, ist in der Ebene der Antiwellenleiterschicht uniform entlang der Längserstreckung der Antiwellenleiterschicht.

In einer weiteren Ausführungsvariante der Erfindung kann die Antiwellenleiterschicht nicht aus einer einzelnen Schicht, sondern aus einer Schichtenfolge bestehen. Die für die Antiwellenleiterschicht genannten Bedingungen gelten dann analog für die Schichtenfolge.

Die Antiwellenleiterschicht kann erfindungsgemäß als Oberflächenschicht ausgebildet werden. Alternativ ist es möglich, die Antiwellenleiterschicht als epitaktisch gewachsene, vergrabende Schicht bestehend aus Verbindungshalbleitern von (Al, In, Ga) und (As, P, Sb, N) auszubilden. Die Herstellung der Antiwellenleiterschicht erfolgt vorzugsweise durch Sputtern, Epitaxie, Implantation oder Diffusion.

Die Antiwellenleiterschicht weist bevorzugt eine laterale Breite größer als $\lambda/n2_{eff}$ auf, bevorzugt größer als 10

x $\lambda/n2_{eff}$, noch bevorzugt größer als 100 x $\lambda/n2_{eff}$.

Die Reflexionsfacette zur Reflexion der von der aktiven Schicht emittierten Strahlung und die Austrittsfacette zur Reflexion und Auskopplung der von der aktiven Schicht emittierten Strahlung sind vorzugsweise im Randbereich der aktiven Schicht angeordnet und liegen sich in Bezug auf die aktive Schicht gegenüber.

Vorzugsweise ist die aktive Schicht uniform ausgebildet. Vorzugsweise erstreckt sich die Uniformität der aktiven Schicht über ihre gesamte Länge, die sich zwischen den Facetten befindet, noch bevorzugter über ihre gesamte Ausdehnung. Uniformität der aktiven Schicht im Sinne der vorliegenden Anmeldung bedeutet, dass die Schichtparameter (wie chemische Zusammensetzung, Dotierung, Schichtdicke, Brechzahl) über die genannte Erstreckung relativ gesehen (Maximum zu Minimum) weniger als 10%, noch bevorzugter weniger als 5%, noch bevorzugter weniger als 1%, besonders bevorzugt gar nicht voneinander abweichen.

Vorzugsweise erstreckt sich die aktive Schicht über den gesamten Bereich zwischen der Reflexionsfacette und der Austrittsfacette. Vorzugsweise kontaktiert die aktive Schicht sowohl die Reflexionsfacette als auch die Austrittsfacette direkt. Die aktive Schicht kann auch von den Facetten in einem Bereich zwischen 0 und 500$\mu$m beabstandet werden, beispielsweise durch Nutzung von Implantation, Intermixing oder Überwachsen, um einen Ausfall des Lasers durch Zerstörung der Facette(n) zu verhindern.

Vorzugsweise sind die erste Mantelschicht und die erste Wellenleiterschicht auf einer ersten Seite der aktiven Schicht und die zweite Wellenleiterschicht und die zweite Mantelschicht auf einer zweiten, gegenüberliegenden Seite der aktiven Schicht angeordnet.

Vorzugsweise ist der Diodenlaser als kantenemittierender Diodenlaser ausgebildet.

Vorzugsweise sind die Oberflächen der Reflexionsfacette und der Austrittsfacette planar ausgebildet. Vorzugsweise sind die Oberflächen der Reflexionsfacette und der Austrittsfacette parallel zueinander angeordnet. Vorzugsweise verlaufen die Längsachse der ersten Wellenleiterschicht und die Längsachse der zweiten Wellenleiterschicht senkrecht zu den Oberflächen der Reflexionsfacette und der Austrittsfacette. Die Wellenleiterschichten im Sinne der vorliegenden Erfindung sind vorzugsweise die von beiden Seiten direkt an die aktive Schicht angrenzenden Schichten. Die Mantelschichten im Sinne der vorliegenden Erfindung sind vorzugsweise diejenigen direkt an die Wellenleiterschichten angrenzenden Schichten, die jeweils von der aktiven Schicht abgewandt sind.

Vorzugsweise sind die Wellenleiterschichten und die Mantelschichten uniform ausgebildet. Vorzugsweise erstreckt sich die Uniformität über ihre gesamte Länge, die sich zwischen den Facetten befindet, noch bevorzugter über ihre gesamte Ausdehnung. Uniformität im Sinne der vorliegenden Anmeldung bedeutet, dass die Schichtparameter (wie chemische Zusammensetzung, Dotierung, Schichtdicke, Brechzahl) über die genannte Erstreckung relativ gesehen (Maximum zu Minimum) weniger als 10%, noch bevorzugter weniger als 5%, noch bevorzugter weniger als 1%, besonders bevorzugt gar nicht voneinander abweichen.

Die Brechzahl der ersten Mantelschicht ist vorzugsweise kleiner als die Brechzahl der ersten Wellenleiterschicht. Die Brechzahl der zweiten Mantelschicht ist vorzugsweise kleiner als die Brechzahl der zweiten Wellenleiterschicht.

Vorzugsweise sind die erste Wellenleiterschicht und die zweite Wellenleiterschicht aus dem gleichen Material ausgebildet.

Vorzugsweise ist ein Trägersubstrat vorgesehen, auf dem die genannte Schichtstruktur aufgebaut ist. Vorzugsweise sind die n-leitenden Schichten auf der Seite der aktiven Schicht angeordnet, die dem Trägersubstrat zugewandt ist, wohingegen die p-leitenden Schichten auf der Seite der aktiven Schicht angeordnet sind, die dem Trägersubstrat abgewandt ist.

Der erfindungsgemäße Diodenlaser ist vorzugsweise derart ausgebildet, dass während des Betriebs neben der lateralen Grundmode mindestens eine laterale Mode höherer Ordnung geführt wird.

Vorzugsweise weist die erste Wellenleiterschicht im aktiven, stromdurchflossenen Gebiet eine (lateral) uniforme Schichtdicke und/oder eine (lateral) uniforme Brechzahl auf. Vorzugsweise weist die zweite Wellenleiterschicht im aktiven, stromdurchflossenen Gebiet eine (lateral) uniforme Schichtdicke und/oder eine (lateral) uniforme Brechzahl auf.

Vorzugsweise weist die gesamte Antiwellenleiterschicht ein Material auf, das im Wellenlängenbereich zwischen 0.3 $\mu$m bis 2 $\mu$m eine Absorption aufweist, die zwischen 50% und 200% der Absorption der Wellenleiterschichten beträgt.

Vorzugsweise ist die Antiwellenleiterschicht aus GaAs durch Strukturierung einer oberhalb der zweiten Mantelschicht angeordneten Kontaktschicht hergestellt, wobei die zweite Mantelschicht derart ausgebildet ist, dass eine Kopplung möglich ist.

*Kurzbeschreibung der Zeichnungen*

Die Erfindung wird nachfolgend anhand von Ausführungsbeispielen näher erläutert. Es zeigen:

Fig. 1    die Intensitätsverteilung des lateralen Fernfeldes eines herkömmlichen Breitstreifenlasers bei unterschiedlichen Ausgangsleistungen,

Fig. 2a      eine erfindungsgemäße Laserdiode in schematischer geschnittener Darstellung,

Fig. 2b      die Bereiche des erfindungsgemäßen Breitstreifenlasers, die zur Bestimmung der Werte von $n_{eff}1$ und $n_{eff}2$ relevant sind,

Fig. 3a - 3g      die unterschiedlichen Möglichkeiten der Implementierung der Antiwellenleiterschicht als vergrabene Schicht oder als Oberflächenschicht,

Fig. 4      die Abhängigkeit des resonanten Verlusts der lateralen Obermoden von der Schichtdicke der Antiwellenleiterschicht für ein bevorzugtes Ausführungsbeispiel, und

Fig. 5      die Abhängigkeit der effektiven Brechungsindices $n1_{eff}$ im aktiven Gebiet und $n2_{eff}$ im Gebiet seitlich des aktiven Gebiets von der Schichtdicke der Antiwellenleiterschicht für unterschiedliche laterale Obermoden.

*Ausführliche Beschreibung der Zeichnungen*

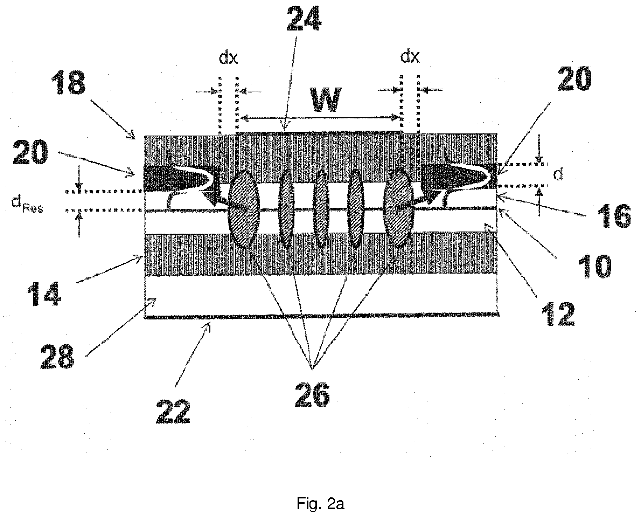

Fig. 2a zeigt einen erfindungsgemäßen Breitstreifenlaser in schematischer geschnittener Darstellung.

Die erfindungsgemäße Laserdiode weist einen vertikalen Schichtaufbau mit einem Substrat 28, einer darauf angeordneten, ersten n-leitenden Mantelschicht 14, einer darauf angeordneten, ersten n-leitenden Wellenleiterschicht 12, einer darauf angeordneten aktiven Schicht 10, einer darauf angeordneten, zweiten p-leitenden Wellenleiterschicht 16 und einer darauf angeordneten, zweiten p-leitenden Mantelschicht 18 auf.

Weiterhin weist die erfindungsgemäße Laserdiode an den (vorderen und hinteren) gegenüberliegenden Enden eine Reflexionsfacette (in der Schnittansicht nicht dargestellt) mit einer hohen Reflektivität für die Zentralwellenlänge der von der aktiven Schicht 10 emittieren Strahlung und eine Austrittsfacette (in der Schnittansicht nicht dargestellt) mit einer Reflektivität, die eine Auskopplung der Strahlung ermöglicht, auf. Die Reflektivität der Reflexionsfacette beträgt vorzugsweise größer 0.8, noch bevorzugter größer 0.9 und noch bevorzugter größer 0.99. Die Reflektivität der Austrittsfacette ist kleiner als die Reflektivität der Reflexionsfacette.

Weiterhin weist die erfindungsgemäße Laserdiode Kontakte 22 und 24 zur Injektion von Ladungsträgern auf. Durch die so gebildete Struktur können Ladungsträger einer ersten Polarität jeweils über den ersten Kontakt 22, die erste Mantelschicht 14 (hier n-leitend) und die erste Wellenleiterschicht 12 (hier n-leitend) in die aktive Schicht 10 und Ladungsträger der entgegengesetzten Polarität jeweils über den zweiten Kontakt 24, die zweite Mantelschicht 18 (hier p-leitend) und die zweite Wellenleiterschicht 16 (hier p-leitend) ebenfalls in die aktive Schicht 10 gelangen und dort rekombinieren, wodurch eine Emission hervorgerufen wird. Die Facetten bilden eine Kavität, so dass ein Laserbetrieb erreicht werden kann.

Die erfindungsgemäße Laserdiode ist als Breitstreifenlaser ausgebildet, d. h. die minimale Breite des aktiven Gebiets beträgt 10 $\mu$m, bevorzugter zwischen 20 und 800 $\mu$m, und noch bevorzugter zwischen 30 und 400 $\mu$m. Durch das Pumpen großer Flächen können hohe Leistungen erzielt werden. Das aktive Gebiet ist der zwischen den Kontakten 22, 24 eingeschlossene Bereich, wobei dieser Bereich durch senkrechte Projektion des weniger breiten Kontakts 24 definiert ist. Aufgrund der Erwärmung insbesondere im aktiven Gebiet direkt unter dem Kontaktstreifen 24 wird ein thermisch induzierter Wellenleiters erzeugt, der mit zunehmender Ausgangsleistung laterale Moden höherer Ordnung stabil anregt, wodurch es zu einer ungewollten lateralen Aufweitung der emittierten Strahlung kommen kann.

Zur Unterdrückung lateraler Moden höherer Ordnung wird erfindungsgemäß eine Antiwellenleiterschicht 20 auf beiden Seiten des aktiven Gebiets vorgesehen, wobei die Antiwellenleiterschicht 20 einen lateralen Abstand $d_x$ vom aktiven Gebiet bevorzugt zwischen 0 und 50 $\mu$m, bevorzugter zwischen 5 und 50 $\mu$m und noch bevorzugter zwischen 10 und 50 $\mu$m aufweist und eine Brechzahl besitzt. Es kann eine resonante Auskopplung lateraler Moden höherer Ordnung realisiert werden, was vorteilhafterweise zu einer geringen Fernfelddivergenz der emittieren Strahlung führt. Die Resonanz zwischen dem zentralen Wellenleiter und der Antiwellenleiterbereichen erzeugt einen sehr großen Verlust, aber nur wenn die Moden in dem Streifenbereich und der Antiwellenleiterbereichen räumlich überlappen. Die Nutzung von einem lateralen Abstand lässt die Auskopplungsstärke und den konsequenten Verlust maßgeschneidert werden.

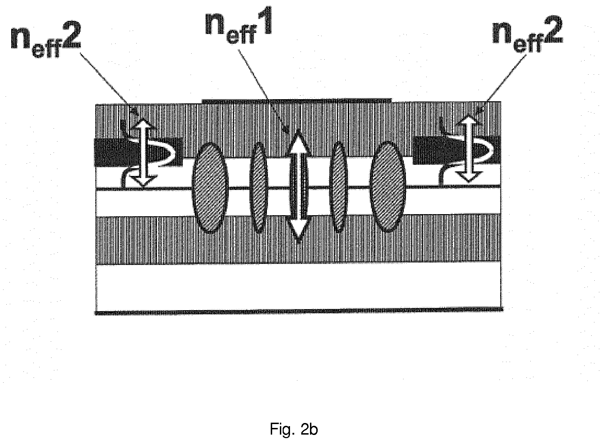

Fig. 2b veranschaulicht die zwei Bereiche des erfindungsgemäßen Breitstreifenlasers, die zur Bestimmung der Werte von $n_{eff}1$ und $n_{eff}2$ relevant sind.

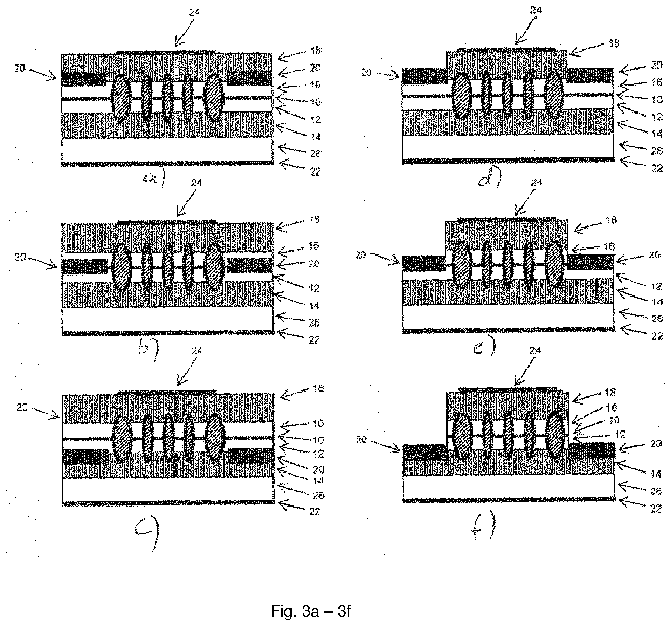

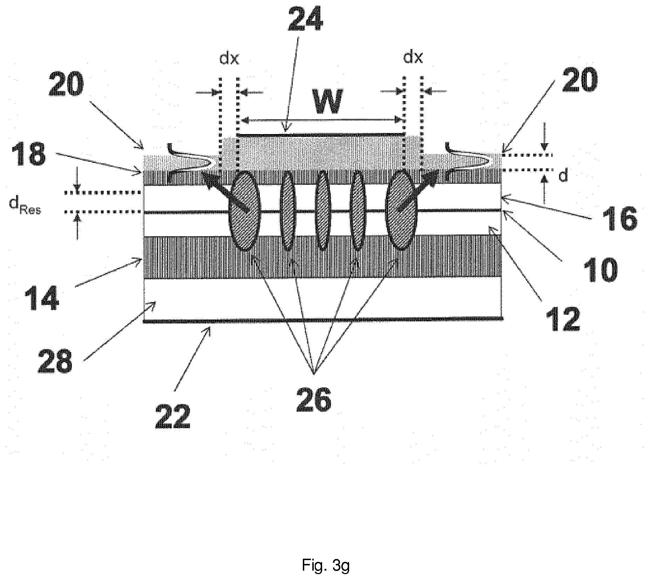

Fig. 3a bis 3g zeigen die unterschiedlichen Möglichkeiten der Implementierung der Antiwellenleiterschichten 20 als vergrabene Schicht oder als Oberflächenschicht. Wie zu erkennen ist, können die Antiwellenleiterschichten 20 als vergrabene Schicht (Fig. 3a bis 3c) implementiert werden, wobei der Diodenlaser dann keinen Rippenwellenleiter besitzt. Alternativ können die Antiwellenleiterschichten 20 als Oberflächenschicht (Fig. 3d bis 3f) implementiert werden, wobei dann ein Rippenwellenleiter ausgebildet werden kann. In den Fig. 3a - 3f befinden sich die Antiwellenleiterschichten 20 vertikal innerhalb der Mantelschichten 14, 18, bevorzugt innerhalb des Bereichs der Wellenleiterschichten 12, 16 (Fig. 3b und 3e). Ein alternatives Ausführungsbeispiel ist in Fig. 3g veranschaulicht. Dort befindet sich die Antiwellenleiterschicht 20 oberhalb der zweiten Mantelschicht 18 und die zweite Mantelschicht 18 ist so gewählt, dass eine Kopplung möglich ist. Die Antiwellenleiterschicht 20 ist aus GaAs durch Strukturierung einer Kontaktschicht hergestellt.

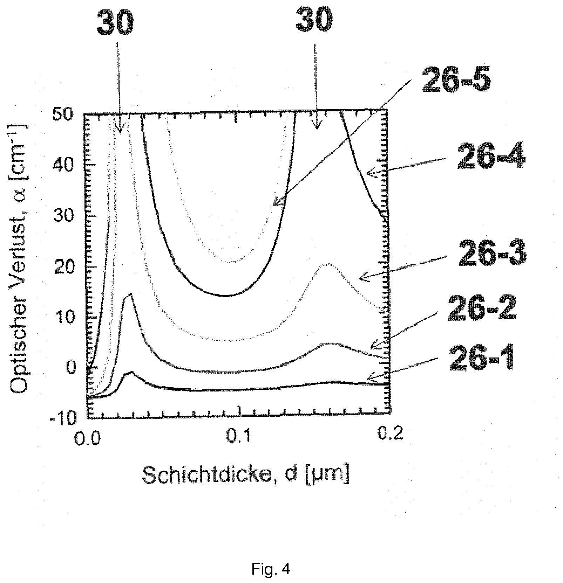

Fig. 4 zeigt die Abhängigkeit des resonanten Verlusts der lateralen Moden 1. Ordnung (26-1) bis 5. Ordnung (26-5) von der Schichtdicke (d) der Antiwellenleiterschicht 20 für ein bevorzugtes Ausführungsbeispiel gemäß der Fig. 3d. Die Laserstruktur außer der Antiwellenleiterschicht 20 entspricht genau der Laserstruktur, wie die von C.M. Schultz et al. Electron. Lett. 46, 580 (2010) publiziert wurde, d. h. die von Schultz et al. offenbarte Laserstruktur verfügt über keine Antiwellenleiterschicht. Die Antiwellenleiterschicht 20 besteht im Ausführungsbeispiel aus Germanium, das bei der Zentrallaserwellenlänge der aktiven Schicht von 975 nm eine Brechzahl von $n_{AWL} = 5$ und einen Extinktionskoeffizienten von $k_{AWL} = 0.3$ besitzt. Die Streifenbreite W des zweiten Kontakts beträgt 10 $\mu$m, der laterale Abstand $d_x = 0$ und der vertikale Abstand von der aktiven Schicht 10 bzw. die Restschichtdicke $d_{res} = 500$ nm (Definition von $d_x$ und $d_{res}$ siehe Fig. 2).

Wie aus Fig. 4 ersichtlich ist, findet ein resonanter Verlust 30 bei Schichtdicken der Antiwellenleiterschicht 20 im Bereich 10 nm bis 50 nm und 120 nm bis 230 nm statt. Insbesondere gibt es Resonanzen bei 30 nm und 170 nm. Es gibt somit unterschiedliche Schichtdicken der Antiwellenleiterschicht 20, bei denen die lateralen Moden höherer Ordnung effizient unterdrückt werden können. Der Verlust der lateralen Obermoden steigt mit Modenordnung aufgrund ihrer divers lateralen Ausdehnung - die lateralen Moden höherer Ordnung überlagern sich räumlich mehrfach mit dem Bereich der Antiwellenleiterschicht 20.

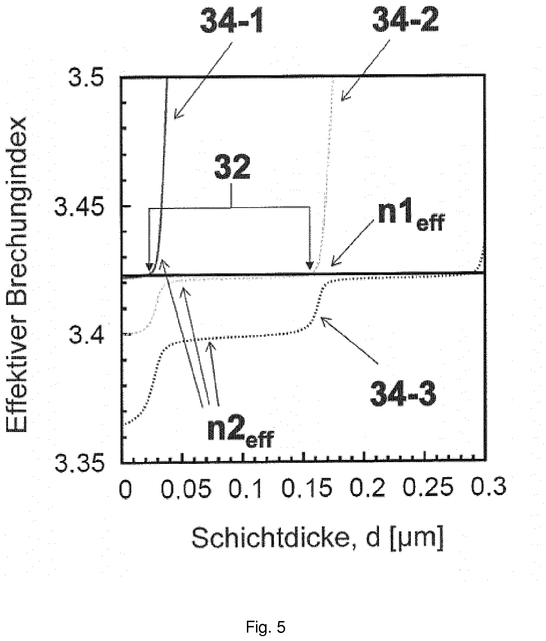

Fig. 5 zeigt die Abhängigkeit des effektiven Brechungsindex $n1_{eff}$ im aktiven Gebiet einerseits und des effektiven Brechungsindex $n2_{eff}$ im Gebiet seitlich des aktiven Gebiets andererseits von der Schichtdicke der Antiwellenleiterschicht 20 für unterschiedliche Antiwellenleitermoden höherer Ordnung (34-1, 34-2, 34-3). Jedoch variiert der effektive Brechungsindex $n2_{eff}$ (34-1, 34-2, 34-3) im Gebiet seitlich des aktiven Gebiets für die einzelnen Obermoden. Eine effiziente Auskopplung der Obermoden kann insbesondere für Schichtdicken der Antiwellenleiterschicht 20 erreicht werden, für die der effektive Brechungsindex $n1_{eff}$ und der effektive Brechungsindex $n2_{eff}$ gleich oder nahezu gleich sind, also Resonanzen 30 vorliegen. Dies ist für die Antiwellenleitermode 1. Ordnung bei 30 nm und für die Antiwellenleitermode 2. Ordnung bei 170 nm der Fall.

**Bezugszeichenliste**

| | |
|---|---|
| 10 | Aktive Schicht |
| 12 | Erste Wellenleiterschicht (n-leitend) |
| 14 | Erste Mantelschicht (n-leitend) |
| 16 | Zweite Wellenleiterschicht (p-leitend) |
| 18 | Zweite Mantelschicht (p-leitend) |
| 20 | Antiwellenleiterschicht |
| 22 | Erster Kontakt |
| 24 | Zweiter Kontakt |
| 26 | Laterale Obermode höherer Ordnung |
| 26-i | Laterale Obermode i-ter Ordnung |
| 28 | Substrat |
| 30 | Resonanter Verlust |
| 32 | Resonanz |
| 34-i | Brechungsindex der laterale Obermoden i-ter Ordnung |
| W | Breite des zweiten Kontakts |
| d | Dicke der Antiwellenleiterschicht |
| $d_x$ | Lateraler Abstand zwischen Antiwellenleiterschicht und aktivem Gebiet |
| $d_{Res}$ | Vertikaler Abstand zwischen Antiwellenleiterschicht und aktiver Schicht |

**Patentansprüche**

1. Diodenlaser, aufweisend:

einen ersten Kontakt (22) mit einer ersten lateralen Breite zur Injektion von Ladungsträgern;
eine erste Mantelschicht (14), wobei der erste Kontakt (22) die erste Mantelschicht (14) kontaktiert;
eine erste Wellenleiterschicht (12), die auf der ersten Mantelschicht (14) angeordnet ist;
eine aktive Schicht (10), die zur Strahlungserzeugung geeignet ist und die auf der ersten Wellenleiterschicht

EP 2 523 279 B1

(12) angeordnet ist;
eine zweite Wellenleiterschicht (16), die auf der aktiven Schicht (10) angeordnet ist;
eine zweite Mantelschicht (18), die auf der zweiten Wellenleiterschicht (16) angeordnet ist; und
einen zweiten Kontakt (24) mit einer zweiten lateralen Breite (W) zur Injektion von Ladungsträgern, wobei der zweite Kontakt (24) die zweite Mantelschicht (18) kontaktiert; wobei die erste Mantelschicht (14), die erste Wellenleiterschicht (12), die aktive Schicht (10), die zweite Wellenleiterschicht (16), und die zweite Mantelschicht (18) als Schichtenstapel ausgebildet sind, welcher sich in longitudinaler Richtung zwischen einer Austrittsfacette und einer Reflexionsfacette erstreckt; wobei sich die aktive Schicht (10), der erste Kontakt (22) und der zweite Kontakt (24) jeweils zumindest teilweise zwischen der Austrittsfacette und der Reflexionsfacette erstrecken; und wobei der zwischen den Kontakten (22, 24) durch senkrechte Projektion des zweiten Kontaktes (24) auf den ersten Kontakt (22) bei der Projektion in vertikaler Richtung gemeinsam eingeschlossene Bereich ein stromdurchflossenes aktives Gebiet ausbildet;
wobei die aktive Schicht (10), der erste Kontakt (22) und der zweite Kontakt (24) jeweils eine laterale Breite (W) größer als 10 $\mu$m aufweisen, das stromdurchflossene Gebiet im Bereich der aktiven Schicht eine Breite größer 10 $\mu$m aufweist, und eine Antiwellenleiterschicht (20) außerhalb des aktiven Gebiets in dem Schichtenstapel angeordnet ist, wobei die Antiwellenleiterschicht (20) zur resonanten Auskopplung lateraler Moden höherer Ordnung aus dem aktiven Gebiet ausgebildet ist, wobei die Brechzahl der Antiwellenleiterschicht (20) größer als die minimale Brechzahl der Mantelschichten (14, 22) ist, und wobei ein minimaler lateraler Abstand ($d_x$) zwischen der Antiwellenleiterschicht (20) und einer Projektion einer der Kontakte (22, 24) in die Ebene der Antiwellenleiterschicht (20) zwischen 0 und 100 $\mu$m beträgt;
**dadurch gekennzeichnet, dass**
eine vertikale Dicke (d) der Antiwellenleiterschicht (20) und die Brechzahl n der Antiwellenleiterschicht (20) die Bedingung (1) erfüllt:

$$(1) \qquad 0 \leq ( n1_{eff} - n2_{eff} ) < 0.15$$

wobei $n1_{eff}$ der effektive Brechungsindex im aktiven Gebiet und $n2_{eff}$ der effektive Brechungsindex im Bereich der Antiwellenleiterschicht (20) ist.

2. Diodenlaser nach Anspruch 1, wobei
die Antiwellenleiterschicht (20) vollständig außerhalb des zwischen den Kontakten (22, 24) eingeschlossenen, aktiven Gebiets angeordnet ist.

3. Diodenlaser nach einem der vorhergehenden Ansprüche, wobei
die vertikale Dicke (d) der Antiwellenleiterschicht (20) und die Brechzahl (n) der Antiwellenleiterschicht (20) die Bedingung (2) erfüllt:

$$(2) \qquad 0 \leq ( n1_{eff} - n2_{eff} ) < 0.10.$$

4. Diodenlaser nach einem der vorhergehenden Ansprüche, wobei
die vertikale Dicke (d) der Antiwellenleiterschicht (20) und die Brechzahl (n) der Antiwellenleiterschicht (20) die Bedingung (3) erfüllt:

$$(3) \qquad 0 \leq ( n1_{eff} - n2_{eff} ) < 0.05.$$

5. Diodenlaser nach einem der vorhergehenden Ansprüche, wobei

ein minimaler vertikaler Abstand ($d_{Res}$) zwischen der aktiven Schicht (10) und der Antiwellenleiterschicht (20) kleiner oder gleich als die Summe der Schichtdicke der ersten Mantelschicht (14) und der Schichtdicke der ersten Wellenleiterschicht (12) ist, und/oder
der minimale vertikale Abstand ($d_{Res}$) zwischen der aktiven Schicht (10) und der Antiwellenleiterschicht (20) kleiner als die Summe der Schichtdicke der zweiten Mantelschicht (18) und der Schichtdicke der zweiten Wellenleiterschicht (16) ist.

6. Diodenlaser nach einem der vorhergehenden Ansprüche, wobei

die erste Mantelschicht (14) und die erste Wellenleiterschicht (12) n-leitend und die zweite Mantelschicht (18) und die zweite Wellenleiterschicht (16) p-leitend ausgebildet sind, wobei ein minimaler vertikaler Abstand ($d_{Res}$) zwischen der aktiven Schicht (10) und der Antiwellenleiterschicht (20) zwischen 40% und 100% der Schichtdicke der zweiten Wellenleiterschicht (16) beträgt.

7. Diodenlaser nach einem der vorhergehenden Ansprüche, wobei der minimale laterale Abstand ($d_x$) zwischen der Antiwellenleiterschicht (20) und dem zweiten Kontakt (22) zwischen 0 und 50 $\mu$m, bevorzugter zwischen 5 und 50 $\mu$m, noch bevorzugter zwischen 10 und 50 $\mu$m beträgt.

8. Diodenlaser nach einem der vorhergehenden Ansprüche, wobei
die aktive Schicht (10), der erste Kontakt (22) und der zweite Kontakt (24) jeweils eine laterale Breite (W) zwischen 20 und 800 $\mu$m, bevorzugter zwischen 30 und 400 $\mu$m aufweisen.

9. Diodenlaser nach einem der vorhergehenden Ansprüche, wobei
die Antiwellenleiterschicht (20) aus Germanium oder Galliumarsenid ausgebildet ist.

10. Diodenlaser nach einem der vorhergehenden Ansprüche, wobei
die Antiwellenleiterschicht (20) aus GaAs durch Strukturierung einer oberhalb der zweiten Mantelschicht (18) angeordneten Kontaktschicht hergestellt ist, wobei die zweite Mantelschicht (18) derart ausgebildet ist, dass eine Kopplung möglich ist.

**Claims**

1. Diode laser, comprising:

a first contact (22) having a first lateral width for injection of charge carriers;
a first cladding layer (14), wherein the first contact (22) contacts the first cladding layer (14);
a first waveguide layer (12) arranged on the first cladding layer (14);
an active layer (10) suitable for generating radiation, which is arranged on the first waveguide layer (12);
a second waveguide layer (16) disposed on the active layer (10);
a second cladding layer (18) disposed on the second waveguide layer (16); and
a second contact (24) having a second lateral width (W) for injection of charge carriers, the second contact (24) contacting the second cladding layer (18); wherein the first cladding layer (14), the first waveguide layer (12), the active layer (10), the second waveguide layer (16), and the second cladding layer (18) are formed as a layer stack extending in the longitudinal direction between an exit facet and a reflection facet; wherein the active layer (10), the first contact (22) and the second contact (24) each extend at least partially between the exit facet and the reflection facet; and wherein the region commonly enclosed between the contacts (22, 24) by perpendicular projection of the second contact (24) onto the first contact (22) when projected in the vertical direction forms a current-carrying active region;
wherein the active layer (10), the first contact (22) and the second contact (24) each have a lateral width (W) greater than 10 $\mu$m, the current-carrying region in the region of the active layer has a width greater than 10 $\mu$m, and an anti-waveguide layer (20) is arranged outside the active region in the layer stack, wherein the anti-waveguide layer (20) is designed for resonant decoupling of lateral modes of higher order from the active region,
wherein the refractive index of the anti-waveguide layer (20) is greater than the minimum refractive index of the cladding layers (14, 22), and wherein a minimum lateral distance ($d_x$) between the anti-waveguide layer (20) and a projection of one of the contacts (22, 24) into the plane of the anti-waveguide layer (20) is between 0 and 100 $\mu$m;
**characterised in that**
a vertical thickness (d) of the anti-waveguide layer (20) and the refractive index n of the anti-waveguide layer (20) satisfies condition (1):

$$(1) \qquad 0 \leq (n1_{eff} - n2_{eff}) < 0.15$$

where $n1_{eff}$ is the effective refractive index in the active region and $n2_{eff}$ is the effective refractive index in the region of the anti-waveguide layer (20).

**2.** Diode laser according to claim 1, wherein
the anti-waveguide layer (20) is arranged completely outside the active region enclosed between the contacts (22, 24).

**3.** Diode laser according to any one of the preceding claims, wherein
the vertical thickness (d) of the anti-waveguide layer (20) and the refractive index (n) of the anti-waveguide layer (20) satisfy condition (2):

$$(2) \qquad 0 \leq (n1_{eff} - n2_{eff}) < 0.10.$$

**4.** Diode laser according to any one of the preceding claims, wherein
the vertical thickness (d) of the anti-waveguide layer (20) and the refractive index (n) of the anti-waveguide layer (20) satisfy condition (3):

$$(3) \qquad 0 \leq (n1_{eff} - n2_{eff}) < 0.05.$$

**5.** Diode laser according to any one of the preceding claims, wherein
a minimum vertical distance ($d_{Res}$) between the active layer (10) and the anti-waveguide layer (20) is less than or equal to the sum of the layer thickness of the first cladding layer (14) and the layer thickness of the first waveguide layer (12), and/or the minimum vertical distance ($d_{Res}$) between the active layer (10) and the anti-waveguide layer (20) is smaller than the sum of the layer thickness of the second cladding layer (18) and the layer thickness of the second waveguide layer (16).

**6.** Diode laser according to any one of the preceding claims, wherein
the first cladding layer (14) and the first waveguide layer (12) are formed n-type and the second cladding layer (18) and the second waveguide layer (16) are formed p-type, wherein a minimum vertical distance ($d_{Res}$) between the active layer (10) and the anti-waveguide layer (20) is between 40% and 100% of the layer thickness of the second waveguide layer (16).

**7.** Diode laser according to any one of the preceding claims, wherein
the minimum lateral distance ($d_x$) between the anti-waveguide layer (20) and the second contact (22) is between 0 and 50 $\mu$m, more preferably between 5 and 50 $\mu$m, even more preferably between 10 and 50 $\mu$m.

**8.** Diode laser according to any one of the preceding claims, wherein
the active layer (10), the first contact (22) and the second contact (24) each have a lateral width (W) between 20 and 800 $\mu$m, more preferably between 30 and 400 $\mu$m.

**9.** Diode laser according to any one of the preceding claims, wherein
the anti-waveguide layer (20) is made of germanium or gallium arsenide.

**10.** Diode laser according to any one of the preceding claims, wherein
the anti-waveguide layer (20) is made of GaAs by patterning a contact layer arranged above the second cladding layer (18), the second cladding layer (18) being formed in such a way that coupling is possible.

**Revendications**

**1.** Laser à diode, comprenant

un premier contact (22) ayant une première largeur latérale pour l'injection de porteurs de charge ;
une première couche de revêtement (14), le premier contact (22) étant en contact avec la première couche de revêtement (14) ;
une première couche de guide d'ondes (12) disposée sur la première couche de revêtement (14) ;
une couche active (10) adaptée pour générer un rayonnement et disposée sur la première couche de guide d'ondes (12) ;
une deuxième couche de guide d'ondes (16) disposée sur la couche active (10) ;
une deuxième couche de revêtement (18) disposée sur la deuxième couche de guide d'ondes (16) ; et

un deuxième contact (24) ayant une deuxième largeur latérale (W) pour l'injection de porteurs de charge, le deuxième contact (24) étant en contact avec la deuxième couche de revêtement (18) ; la première couche de revêtement (14), la première couche de guide d'ondes (12), la couche active (10), la deuxième couche de guide d'ondes (16), et la deuxième couche de revêtement (18) étant formées comme un empilement de couches qui s'étend dans la direction longitudinale entre une facette de sortie et une facette de réflexion ; la couche active (10), le premier contact (22) et le deuxième contact (24) s'étendant chacun au moins partiellement entre la facette de sortie et la facette de réflexion ; et la zone incluse entre les contacts (22, 24) par projection perpendiculaire du deuxième contact (24) sur le premier contact (22) lors de la projection dans la direction verticale formant ensemble une région active traversée par le courant ;

la couche active (10), le premier contact (22) et le deuxième contact (24) présentant chacun une largeur latérale (W) supérieure à 10 $\mu$m, la region traversée par le courant dans la zone de la couche active présentant une largeur supérieure à 10 $\mu$m, et une couche anti-guide d'ondes (20) étant disposée à l'extérieur de la région active dans l'empilement de couches, la couche anti-guide d'ondes (20) étant conçue pour le découplage résonant de modes latéraux d'ordre supérieur à partir de la region active, l'indice de réfraction de la couche anti-guide d'ondes (20) étant supérieur à l'indice de réfraction minimal des couches de revêtement (14, 22), et une distance latérale minimale ($d_x$) entre la couche anti-guide d'ondes (20) et une projection de l'un des contacts (22, 24) dans le plan de la couche anti-guide d'ondes (20) étant comprise entre 0 et 100 $\mu$m ;

**caractérisé en ce que**

une épaisseur verticale (d) de la couche anti-guide d'ondes (20) et l'indice de réfraction n de la couche anti-guide d'ondes (20) satisfait la condition (1) :

$$(1) \qquad 0 \le (n1_{eff} - n2_{eff}) < 0.15$$

où $n1_{eff}$ est l'indice de réfraction effectif dans la région active et $n2_{eff}$ est l'indice de réfraction effectif dans la région de la couche anti-guide d'ondes (20).

2. Laser à diode selon la revendication 1, dans lequel
   la couche anti-guide d'ondes (20) est disposée complètement à l'extérieur de la région active enfermée entre les contacts (22, 24).

3. Laser à diode selon l'une quelconque des revendications précédentes, dans lequel l'épaisseur verticale (d) de la couche anti-guide d'ondes (20) et l'indice de réfraction (n) de la couche anti-guide d'ondes (20) satisfont à la condition (2) :

$$(2) \qquad 0 \le (n1_{eff} - n2_{eff}) < 0,10.$$

4. Laser à diode selon l'une quelconque des revendications précédentes, dans lequel l'épaisseur verticale (d) de la couche anti-guide d'ondes (20) et l'indice de réfraction (n) de la couche anti-guide d'ondes (20) satisfont à la condition (3) :

$$(3) \qquad 0 \le (n1_{eff} - n2_{eff}) < 0,05.$$

5. Laser à diode selon l'une quelconque des revendications précédentes, dans lequel une distance verticale minimale ($d_{Res}$) entre la couche active (10) et la couche anti-guide d'ondes (20) est inférieure ou égale à la somme de l'épaisseur de couche de la première couche de revêtement (14) et de l'épaisseur de couche de la première couche de guide d'ondes (12), et/ou
   la distance verticale minimale ($d_{Res}$) entre la couche active (10) et la couche anti-guide d'ondes (20) est inférieure à la somme de l'épaisseur de couche de la deuxième couche de revêtement (18) et de l'épaisseur de couche de la deuxième couche de guide d'ondes (16).

6. Laser à diode selon l'une quelconque des revendications précédentes, dans lequel la première couche de revêtement (14) et la première couche de guide d'ondes (12) sont à conduction n et la deuxième couche de revêtement (18) et la deuxième couche de guide d'ondes (16) sont à conduction p, une distance verticale minimale ($d_{Res}$) entre la couche active (10) et la couche anti-guide d'ondes (20) étant comprise entre 40% et 100% de l'épaisseur de la deuxième couche de guide d'ondes (16).

**7.** Laser à diode selon l'une quelconque des revendications précédentes, dans lequel la distance latérale minimale $(d_x)$ entre la couche anti-guide d'ondes (20) et le deuxième contact (22) est comprise entre 0 et 50 $\mu$m, de préférence entre 5 et 50 $\mu$m, de manière encore plus préférée entre 10 et 50 $\mu$m.

**8.** Laser à diode selon l'une quelconque des revendications précédentes, dans lequel la couche active (10), le premier contact (22) et le deuxième contact (24) ont chacun une largeur latérale (W) comprise entre 20 et 800 $\mu$m, de préférence entre 30 et 400 $\mu$m.

**9.** Laser à diode selon l'une quelconque des revendications précédentes, dans lequel la couche anti-guide d'ondes (20) est formée de germanium ou d'arséniure de gallium.

**10.** Laser à diode selon l'une quelconque des revendications précédentes, dans lequel la couche anti-guide d'ondes (20) est fabriquée en GaAs par structuration d'une couche de contact disposée au-dessus de la deuxième couche de revêtement (18), la deuxième couche de revêtement (18) étant formée de telle sorte qu'un couplage est possible.

(Stand der Technik)

Fig. 1

Fig. 2a

Fig. 2b

Fig. 3a – 3f

Fig. 3g

Fig. 4

Fig. 5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 4965806 A
- US 6141365 A
- WO 2004027951 A1
- WO 2010057955 A1
- US 6167073 A
- WO 2006096299 A2
- DE 102008058436 A1

### In der Beschreibung aufgeführte Nicht-Patentliteratur

- **A. K. CHAN et al.** *IEEE J. Quantum. Elec.,* 1988, vol. 24 (3
- **C.M. SCHULTZ et al.** *Electron. Lett.,* 2010, vol. 46, 580